(19) Europäisches Patentamt
European Patent Office
Office européen des brevets

(11) Veröffentlichungsnummer : **0 645 412 A1**

# (12) EUROPÄISCHE PATENTANMELDUNG

(21) Anmeldenummer : **94810529.1**

(22) Anmeldetag : **13.09.94**

(51) Int. Cl.[6] : **C08G 59/32,** C08G 59/40, C08J 5/24

(30) Priorität : **21.09.93 CH 2854/93**

(43) Veröffentlichungstag der Anmeldung : **29.03.95 Patentblatt 95/13**

(84) Benannte Vertragsstaaten : **CH DE ES FR GB IT LI NL SE**

(71) Anmelder : **CIBA-GEIGY AG**
**Klybeckstrasse 141**
**CH-4002 Basel (CH)**

(72) Erfinder : **Knobloch, Wilhelm, Dr.**
**Breslauerstrasse 15A**
**D-79739 Schwörstadt (DE)**
Erfinder : **Roth, Martin, Dr.**
**Oberdorf**
**CH-1735 Giffers (CH)**
Erfinder : **Haug, Theobald, Dr.**
**Untere Flühackerstrasse 12**
**CH-4402 Frenkendorf (CH)**

## (54) Härtbare Laminierharze aus Epoxidharz und Dicyandiamid.

(57) Härtbare Laminierharze, enthaltend
a) postglycidylierte, vorverlängerte und bromhaltige aromatische Diglycidylether der Formel I

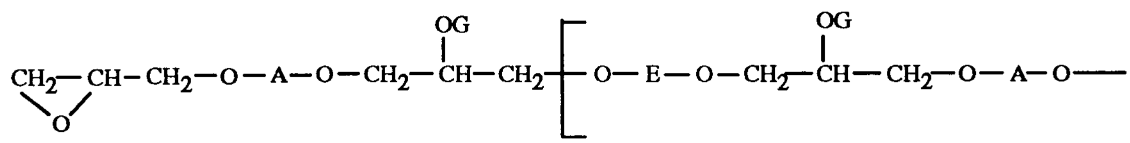

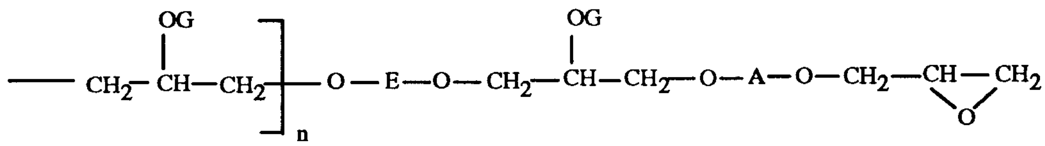

(I),

worin jedes A und jedes E unabhängig voneinander je für einen Rest der Formeln

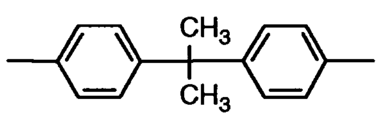

,

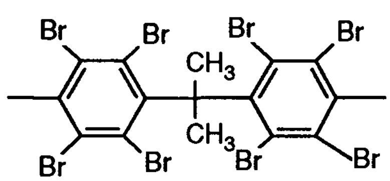

oder

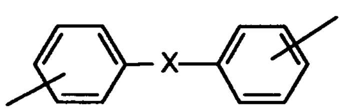

stehen, wobei X für eine direkte Bindung oder $-CH_2-$, -O-, -S- oder $-SO_2-$ steht und mindestens ein A oder E den bromierten Rest der Formel

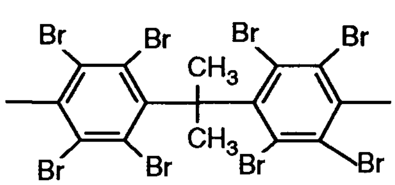

bedeutet,

EP 0 645 412 A1

Jouve, 18, rue Saint-Denis, 75001 PARIS

jedes G unabhängig voneinander je für ein Wasserstoffatom oder eine Glycidylgruppe steht, wobei mindestens ein G eine Glycidylgruppe bedeutet, und
n für null oder eine Zahl von 1 bis 100 steht,
b) Dicyandiamid und
c) gegebenenfalls übliche Zusatzmittel, ergeben Laminate mit hohem Glasumwandlungstemperaturen, guter Kupferhaftung und guter Bohrbarkeit.

Die vorliegende Erfindung betrifft härtbare Laminierharze auf Basis eines postglycidylierten vorverlängerten Epoxidharzes und Dicyandiamid sowie deren Verwendung zur Herstellung von Laminaten, insbesondere von Glasfaserlaminaten.

Im US-Patent 4,623,701 werden postglycidylierte Epoxidharze von sowohl multifunktionalen Glycidylethern als auch von vorverlängerten Diglycidylethern beschrieben, die mit den üblichen Härtungsmitteln für Epoxidharze ausgehärtet werden können. Bei Verwendung von Bis-(4-aminophenyl)-methan (Methylendianilin) als Härtungsmittel, wie es in den Beispielen ausschliesslich eingesetzt wird, werden an den ausgehärteten postglycidylierten Epoxidharzen relativ hohe Glasübergangstemperaturen (Tg-Werte) erhalten, wobei diese an den mit Bisphenol A vorverlängerten Bisphenol A-diglycidylethern am höchsten sind.

Die Verwendung von Dicyandiamid als Härtungsmittel in Laminierharzen auf Basis von üblichen Epoxidharzen ist ebenfalls bekannt. Dicyandiamid wird bevorzugt wegen seiner Latenz in Laminierharzen verwendet, da die aus solchen Laminierharzen hergestellten Prepregs relativ lagerstabil sind. Die aus diesen Prepregs unter Formgebung erhaltenen Formteile weisen aber den Nachteil von relativ niedrigen Tg-Werten auf. Handelsübliche, Dicyandiamid enthaltende Laminierharze ergeben beispielsweise nach der Härtung Formstoffe mit Tg-Werten bis etwa 140°C.

Es wurde nun gefunden, dass man bei der Aushärtung von postglycidylierten, mit bromiertem Bisphenol vorverlängerten aromatischen Diglycidylethern oder postglycidylierten, mit unsubstituiertem Bisphenol vorverlängerten bromhaltigen aromatischen Bisphenol A-diglycidylethern mittels Dicyandiamid Formstoffe mit höheren Tg-Werten erhält als bei Verwendung von postglycidylierten, mit unsubstituierten Bisphenol A vorverlängerten Diglycidylethern.

Gegenstand vorliegender Erfindung sind somit härtbare Laminierharze enthaltend

a) postglycidylierte, vorverlängerte und bromhaltige aromatische Diglycidylether der Formel I

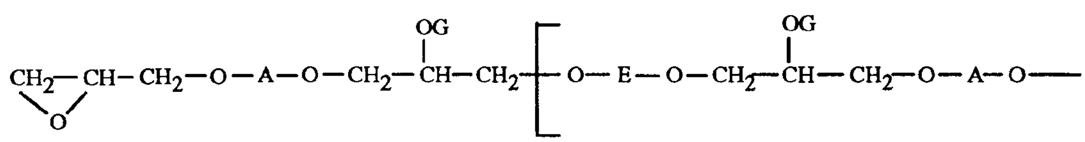

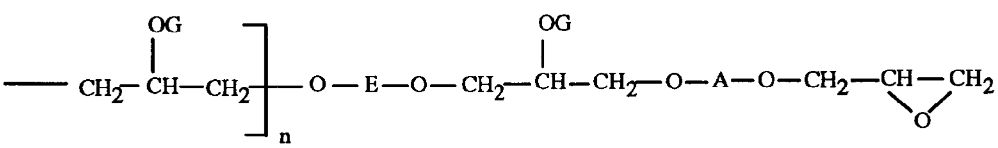 (I),

worin jedes A und jedes E unabhängig voneinander je für einen Rest der Formeln

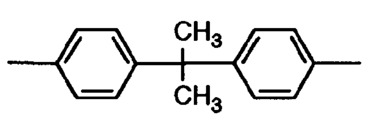 , 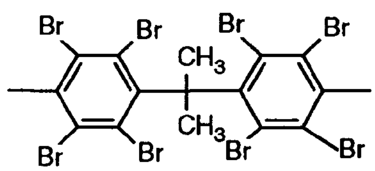

oder

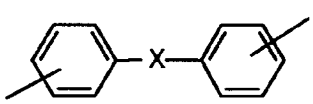

stehen, wobei X für eine direkte Bindung oder $-CH_2-$, -O-, -S- oder $-SO_2-$ steht und mindestens ein A oder E den bromierten Rest der Formel

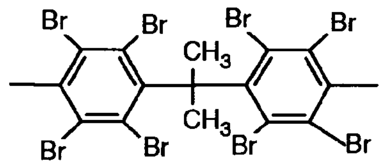

bedeutet,

jedes G unabhängig voneinander je für ein Wasserstoffatom oder eine Glycidylgruppe steht, wobei mindestens ein G eine Glycidylgruppe bedeutet, und

n für null oder eine Zahl von 1 bis 100 steht,

b) Dicyandiamid und

c) gegebenenfalls übliche Zusatzmittel.

Vorzugsweise enthalten die erfindungsgemässen Laminierharze als Komponente a) eine Verbindung der Formel I, worin jedes A und jedes E unabhängig voneinander je einen Rest der Formel

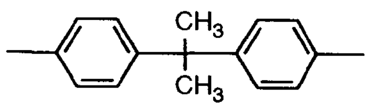 oder 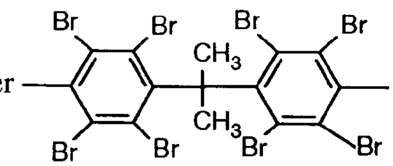

bedeuten.

Die Laminierharze enthalten als Komponente a) insbesondere eine Verbindung der Formel I, worin A für den Rest der Formel

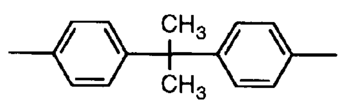

und E für den Rest der Formel

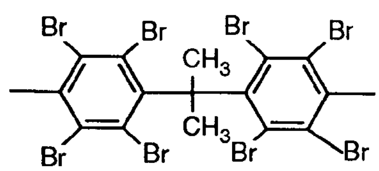

stehen.

In der Formel I bedeutet n vorzugsweise null oder eine Zahl von 1 bis 20, insbesondere null oder eine Zahl von 1 bis 10.

Die Verbindungen der Formel I können hergestellt werden, indem man Verbindungen der Formel II

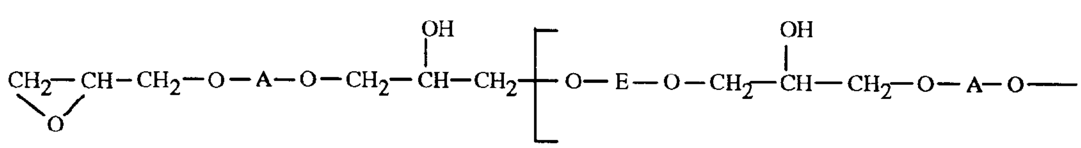

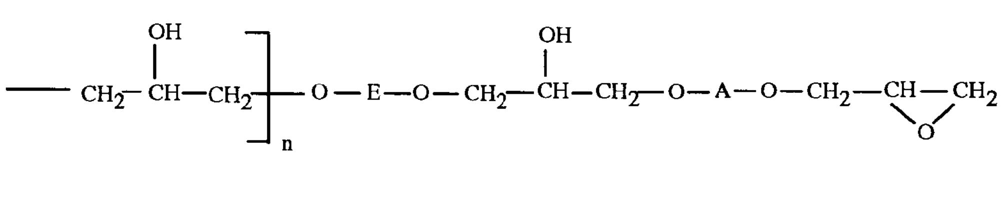 (II),

worin A und E die gleiche Bedeutung wie in Formel I haben, beispielsweise in bekannter Weise mit Epichlorhydrin und in Gegenwart eines alkalischen Katalysators glycidyliert.

Die Verbindungen der Formel II können erhalten werden, indem man einen Diglycidylether der Formel III

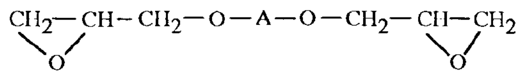 (III),

worin A die gleiche Bedeutung wie in Formel I hat, in bekannter Weise mit einem Bisphenol der Formel HO-E-OH , worin E die gleiche Bedeutung wie in Formel I hat, vorverlängert, indem man beispielsweise n+2 Mole eines Diglycidylethers oder mehrerer Diglycidylether der Formel III mit n+1 Mol eines oder mehrerer Bisphenole der Formel HO-E-OH , wobei n die gleiche Bedeutung wie in Formel I hat, in Gegenwart eines Vorverlängerungskatalysators in bekannter Weise umsetzt.

Vorverlängerungskatalysatoren für Epoxidharze sind dem Fachmann bekannt.
Vorzugsweise werden sekundäre oder tertiäre Amine oder quartäre Ammoniumsalze verwendet.

Beispiele für sekundäre und tertiäre Amine sind aliphatische, cycloaliphatische oder aromatische sekundäre und tertiäre Amine, wie Di-n-butylamin, Triethylamin, Tri-n-butylamin, N,N-Dimethylcyclohexylamin und N,N-Dimethylanilin, heterozyklische Amine, wie Piperidin, N-Methylpiperidin, N-Methylmorpholin, N-Methylpyrrolidin, 2-Phenylimidazol und 2-Ethylimidazol.

Geeignete quartäre Ammoniumsalze sind beispielsweise die in dem US-Patent 4,465,722 erwähnten Tetraalkylammoniumhydroxide und -halogenide sowie die in den US-Patenten 4,885,354, 4,973,648 und 5,006,626 beschriebenen Piperidinium-, Morpholinium- und Pyrrolidiniumsalze, wie zum Beispiel Tetramethylammoniumchlorid, Tetrabutylammoniumbromid, N,N-Dimethylpyrrolidiniumchlorid, N-Ethyl-N-methylpyrrolidiniumiodid, N-Butyl-N-methylpyrrolidiniumbromid, N-Benzyl-N-methylpyrrolidiniumchlorid, N-Butyl-N-methylmorpholiniumbromid, N-Butyl-N-methylmorpholiniumiodid, N-Ethyl-N-hydroxyethylmorpholiniumiodid, N-Allyl-N-methylmorpholiniumbromid, N-Methyl-N-benzylpiperidiniumchlorid, N-Methyl-N-benzylpiperidiniumbromid, N,N-Dimethylpiperidiniumiodid, N-Methyl-N-ethylpiperidiniumacetat oder N-Methyl-N-ethylpiperidiniumiodid.

Die Komponente b) in den erfindungsgemässen Laminierharzen stellt ein bekanntes Härtungsmittel für Epoxidharze dar und ist im Handel erhältlich. Im allgemeinen wird das Dicyandiamid in den erfindungsgemässen Laminierharzen in einer Menge von 1 bis 10 Gewichtsteilen pro 100 Gewichtsteile des postglycidylierten Diglycidylethers der Formel I eingesetzt.

Als übliche Zusatzmittel (c) können die erfindungsgemässen Laminierharze beispielsweise Beschleuniger, reaktive Verdünner, Lösungsmittel, Haftvermittler sowie Streck-, Füll- und Verstärkungsmittel oder Additive, wie Antioxidantien und Lichtschutzmittel, enthalten.

Falls zweckmässig, können die erfindungsgemässen Laminierharze auch Beschleuniger für die Vernetzungsreaktion mit dem Dicyandiamid enthalten. Geeignete Beschleuniger sind beispielsweise Harnstoffderivate, wie N,N-Dimethyl-N'-(3-chlor-4-methylphenyl)harnstoff (Chlortoluron), N,N-Dimethyl-N'-(4-chlorphenyl)harnstoff (Monuron) oder N,N-Dimethyl-N'-(3,4-dichlorphenyl)harnstoff (Diuron), 2,4-Bis(N',N'-dimethylureido)toluol oder 1,4-Bis(N',N'-dimethylureido)benzol. Die Verwendung dieser Verbindungen ist beispielsweise in der US 4,283,520 beschrieben. Als Beschleuniger geeignet sind z.B. auch die in der GB 1,192,790 beschriebenen Harnstoffderivate.

Besonders geeignete Beschleuniger sind Imidazole, wie beispielsweise Imidazol, 2-Ethyl-, 2-Phenyl-, 2-Methyl- und 1-Methylimidazol, ferner 1-Cyanoethyl-2-ethyl4-methylimidazol oder 2-Ethyl-4-methylimidazol.

Weitere geeignete Beschleuniger sind tertiäre Amine, deren Salze oder quaternäre Ammoniumverbindungen, wie Benzyldimethylamin, 2,4,6-Tris(dimethylaminomethyl)phenol, 4-Aminopyridin, Tripentylammoniumphenolat, Tetramethylammoniumchlorid oder Benzyltributylammoniumbromid oder -chlorid; oder Alkalimetallalkoholate, wie Na-Alkoholate von 2,4-Dihydroxy-3-hydroxymethylpentan.

Gewünschtenfalls kann man den Laminierharzen zur Herabsetzung der Viskosität reaktive Verdünner, wie beispielsweise Butandioldiglycidylether, Monoglycidylether isomerer höherer Alkohole, wie z.B. Grilonit RV 1814® der Fa. Ems-Chemie oder Butylglycidylether, 2,2,4-Trimethylpentylglycidylether, Phenylglycidylether, Kresylglycidylether oder Glycidylester zusetzen.

Zur Herabsetzung der Viskosität bzw. zur Herstellung von 40-95%-igen Laminierharzlösungen können den erfindungsgemässen Laminerharzen auch organische Lösungsmittel, wie beispielsweise Methylethylketon, Aceton, Ethylenglykolmonomethylether, Methoxypropanol oder Dimethylformamid, zugesetzt werden.

Die erfindungsgemässen Laminierharze können auch Haftvermittler enthalten. Im Prinzip kann jeder bekannte Haftvermittler verwendet werden. Als besonders geeignete Haftvermittler haben sich Silane, wie z.B.

γ-Glycidyloxypropyltrimethoxysilan (Silan A-187 der Fa. Union Carbide) oder γ-Mercaptopropyltrimethoxysilan (Silan A-189 der Fa. Union Carbide) oder Titanverbindungen, wie Tetraisopropyl-bis(dioctylphosphonato)-titanat (KR 41B der Fa. Kenrich Petrochemicals, Inc. USA), erwiesen.

Als weitere übliche Zusätze können die erfindungsgemässen Laminierharze ferner Streck-. Füll- und Verstärkungsmittel, wie beispielsweise Steinkohlenteer, Bitumen, mineralische Silikate, Glimmer, Quarzmehl, Aluminiumoxidhydrat, Bentonite, Wollastonit, Kaolin, Kieselsäureaerogel oder Metallpulver, z.B. Aluminiumpulver oder Eisenpulver, ferner Pigmente und Farbstoffe, wie Russ, Oxidfarben und Titandioxid, Flammschutzmittel, Thixotropiemittel, Verlaufmittel ("flow control agents"), wie Silicone, Wachse und Stearate, die zum Teil auch als Formtrennmittel Anwendung finden, enthalten.

Die Herstellung der erfindungsgemässen Laminierharze kann beispielsweise durch einfaches Vermischen der Komponenten a), b) und c) erfolgen.

Zur Herstellung von Laminaten aus den erfindungsgemässen Laminierharzen werden Fasergewebe mit einer Lösung enthaltend ein erfindungsgemässes Imprägnierharz imprägniert und kurzzeitig (ca. 2-10 min) auf Temperaturen bis etwa 200 °C erhitzt. Bei diesem Prozess wird das Lösungsmittel entfernt, und das Impregnierharz wird relativ rasch in den noch schmelzbaren bzw. härtbaren B-Zustand überführt, wobei sogenannte Prepregs erhalten werden.

Dabei können die üblichen bei der Faserverstärkung von Werkstoffen verwendeten Fasern eingesetzt werden. Diese können organische oder anorganische Fasern, Naturfasern oder Synthesefasern sein und in Form von Geweben oder Gelegen, Vliesen oder Matten sowie in Form von Fasersträngen (Rovings), als Stapelfasern oder Endlosfasern vorliegen. Beispielsweise verwendet man Glas-, Asbest-, Bor-, Kohlenstoff- oder Metallfasern sowie Aramidfasern, hochfeste Polyesterfasern oder Naturfasern aus Baumwolle oder Zellwolle. Solche Fasern und Gewebe daraus sind im Handel erhältlich.

Das Beschichten dieser Fasern bzw. Gewebe mit dem Imprägnierharz kann nach den üblichen Imprägniermethoden, durch Bestreichen, Besprühen oder Eintauchen, mittels Strangziehtechnik oder bei Endlosfasern nach dem Präzisionsfaserwicklungsverfahren (filament-winding) erfolgen.

Die erhaltenen Prepregs können in bekannter Weise durch Erhitzen auf ca. 100-200 °C vollständig zu Laminaten ausgehärtet werden.

In einer bevorzugten Ausführungsform werden dabei mehrere Lagen solcher Prepregs unter Druck zu Laminaten verpresst.

Die so erhaltenen Laminate zeichnen sich durch hohe Glasumwandlungstemperaturen ($T_g$), gute Kupferhaftungen und eine gute Bohrbarkeit aus, da bei den verwendeten Bohrern im Vergleich beim Bohren von anderen Hoch-$T_g$-Laminaten nur ein geringer Verschleiss auftritt.

Insbesondere finden die erfindungsgemässen Laminierharze Anwendung bei der Herstellung von Leiterplatten für gedruckte Schaltungen.

Herstellung eines postglycidylierten, vorverlängerten Epoxidharzes (Epoxidharz A)

a) 445,00 g eines flüssigen Bisphenol A-diglycidylethers mit einem Epoxidgehalt von 5,1-5,4 Äquivalenten/kg und einer Viskosität von 185-196 mPa·s werden vorgelegt und auf 80°C aufgeheizt. Dazu fügt man 0,043 g Tetramethylammoniumchlorid als 50%-ige Lösung in Ethanol, erhöht die Innentemperatur auf 100°C und gibt 269 g Tetrabrombisphenol A hinzu. Man erhöht die Innentemperatur des Reaktionsgemisches auf 155-160°C und rührt dieses während 5 Stunden. Dabei sinkt der Epoxidgehalt des vorverlängerten Epoxidharzes auf 1,85-1,97 Äquivalente/kg. Man kühlt das Harz auf 100°C ab und verwendet es direkt zur Postglycidylierung.

b) 1171,20 g (2,26 Mol OH-Gruppen) des unter a) erhaltenen Epoxidharzes tel quel und 1416 ml (18,10 Mol) Epichlorhydrin werden in einem Reaktor vorgelegt, und durch Erwärmen wird eine homogene Lösung hergestellt, die man anschliessend auf 80°C abkühlen lässt. Unter guter Rührung und bei einer Innentemperatur von 80°C legt man vorsichtig ein Wasserstrahlvakuum an, so dass Epichlorhydrin unter Rückfluss siedet. Dabei sinkt die Innentemperatur ab und wird auf einen konstanten Wert von etwa 55 °C eingestellt, wobei ein anfänglicher Druck von 110-120 mbar erforderlich ist. Wenn das Epichlorhydrin bei 55°C konstant unter Rückfluss siedet, tropft man aus einem Tropftrichter 24,80 g (0,113 Mol) einer 50%-igen wässrigen Tetramethylammoniumchloridlösung rasch hinzu. Dann werden innerhalb von 2 Stunden aus einem anderen Tropftrichter 162,60 g (2,03 Mol) einer 50%-igen wässrigen Natriumhydroxidlösung zugetropft, und gleichzeitig wird das entstehende und das aus den wässrigen Lösungen stammende Wasser durch azeotrope Destillation mit Epichlorhydrin ausgekreist. Nach dem Zutropfen lässt man die Reaktionslösung bei 55°C unter Wasserauskreisung nachreagieren. Das Vakuum wird abgestellt, und die erhaltene Suspension wird mit 1000 ml Methylethylketon verdünnt. Durch Zugabe von 20%-iger wässriger Natriumhydrogensulfatlösung wird das Reaktionsgemisch neutral gestellt, und die Suspension wird über Hyflo® filtriert. Das klare, gelbliche Filtrat wird am Rotationsverdampfer bei einer Badtemperatur von bis zu 120°C eingeengt. Das noch heisse, flüssige Harz wird in flache Stahlwannen gegossen und im Vakuum (0,001 mbar) bei 150°C während 3 Stunden getrocknet. Nach dem Erkalten lässt sich das Festharz durch Zufügen von etwas flüssigem Stickstoff leicht aus den Stahlwannen herausnehmen.

Man erhält 1050 g eines vorverlängerten, postglycidylierten Epoxidharzes mit folgenden analytischen Daten:

| | |
|---|---|
| Epoxidgehalt (titrimetrisch): | 2,40-3,00 Äquivalente/kg |
| Chlorgehalt | |
| a) gesamtes Chlor: | 0,45%/0,38% |
| b) hydrolysierbares Chlor: | 0,22%/0,22% |
| Molekulargewicht (GPC*) | Mw=3189; Mn=1235. |
| *) Gel Permeation Chromatography | |

<u>Beispiel 1</u>

800 g des vorverlängerten, postglycidylierten Epoxidharzes A werden in 200 g Methylethylketon gelöst. Zu dieser Epoxidharzlösung werden 264 g einer 10%-igen Lösung von Dicyandiamid in Ethylenglykolmonomethylether und 3,2 g einer 10%-igen Lösung von 2-Methylimidazol in Methoxypropanol zugegeben und vermischt. Zur Einstellung einer für Imprägnierungen geeigneten Viskosität werden noch 236 g Ethylenglykolmonomethylether als Verdünnungsmittel zugegeben.

Ein Glasgewebe (200 g/$m^2$) wird mit der oben hergestellten Imprägnierlösung behandelt und bei 160°C während 3 Minuten getrocknet. Dabei wird ein mit nicht klebendem Harz gefüllter Prepreg erhalten. Acht Lagen solcher Prepregs werden während 120 Minuten bei 170°C und einem Druck von 1,96 - 3,92 MPa ausgehärtet. Das so erhaltene Laminat hat eine Glasumwandlungstemperatur von 180°C.

<u>Beispiel 2</u>

300 g des vorverlängerten, postglycidylierten Epoxidharzes A werden in 75 g Methylethylketon gelöst. Zu dieser Lösung werden noch 142,9 g hinzugegeben. Dann gibt man zur Epoxidharzlösung 120,4 g einer 10%-igen Lösung von Dicyandiamid in Ethylenglykolmonomethylether und 1,6 g einer 10%-igen Lösung von 2-Methylimidazol in Methoxypropanol und vermischt alles gut. Zur Einstellung einer für Imprägnierungen geeigneten Viskosität werden noch 124 g Ethylenglykolmonomethylether als Verdünnungsmittel zugegeben.

Ein Glasgewebe (200 g/$m^2$) wird mit der oben hergestellten Imprägnierlösung behandelt und bei 170°C während 4 Minuten und 10 Sekunden getrocknet. Dabei wird ein mit nicht klebendem Harz gefüllter Prepreg erhalten. Acht Lagen solcher Prepregs werden während 90 Minuten bei 180°C und einem Druck von 1,96 - 3,92 MPa ausgehärtet. Das so erhaltene Laminat hat eine Glasumwandlungstemperatur von 168°C.

**Patentansprüche**

1. Härtbare Laminierharze enthaltend

   a) postglycidylierte, vorverlängerte und bromhaltige aromatische Diglycidylether der Formel I

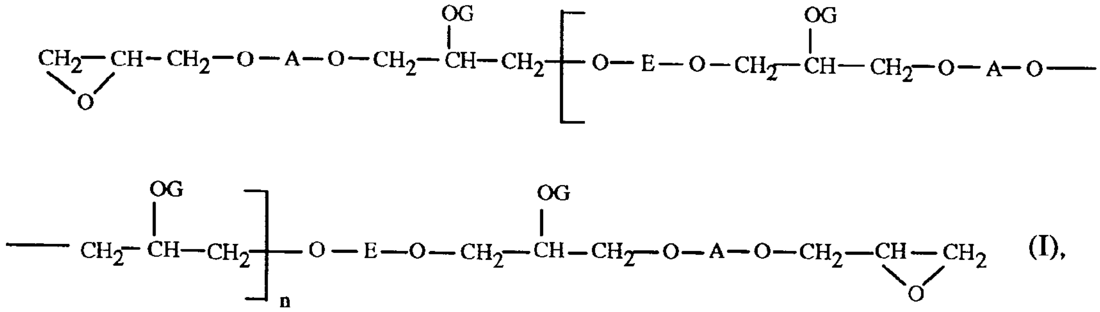

(I),

worin jedes A und jedes E unabhängig voneinander je für einen Rest der Formeln

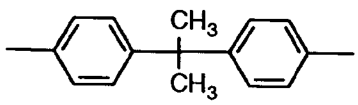,
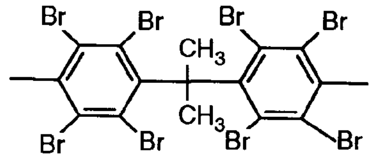

oder

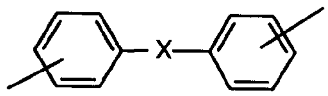

stehen, wobei X für eine direkte Bindung oder $-CH_2-$, -O-, -S- oder $-SO_2-$ steht und mindestens ein A oder E den bromierten Rest der Formel

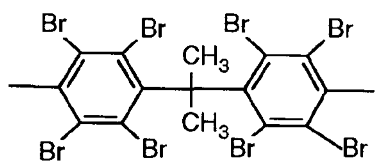

bedeutet,
jedes G unabhängig voneinander je für ein Wasserstoffatom oder eine Glycidylgruppe steht, wobei mindestens ein G eine Glycidylgruppe bedeutet, und
n für null oder eine Zahl von 1 bis 100 steht,
b) Dicyandiamid und
c) gegebenenfalls übliche Zusatzmittel.

2. Laminierharze gemäss Anspruch 1, enthaltend als Komponente a) eine Verbindung der Formel I, worin jedes A und jedes E unabhängig voneinander je einen Rest der Formel

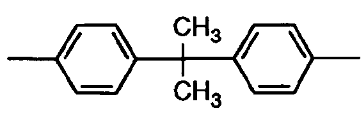
oder
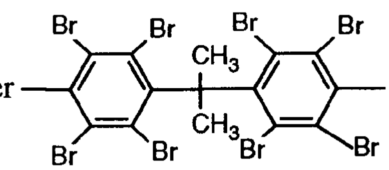

bedeuten.

3. Laminierharze gemäss Anspruch 1, enthaltend als Komponente a) eine Verbindung der Formel I, worin A für den Rest der Formel

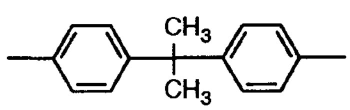

und E für den Rest der Formel

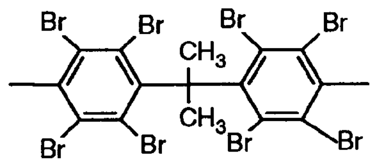

stehen.

4. Laminierharze gemäss Anspruch 1, enthaltend als Komponente a) eine Verbindung der Formel I, worin n für null oder eine Zahl von 1 bis 20 steht.

5. Laminierharze gemäss Anspruch 1, enthaltend als Komponente a) eine Verbindung der Formel I, worin n für null oder eine Zahl von 1 bis 10 steht.

6. Die aus den Laminierharzen gemäss Anspruch 1 durch Imprägnierung von Fasergeweben erhaltenen Prepregs.

7. Die aus den Laminierharzen gemäss Anspruch 1 durch Imprägnierung von Fasergeweben und Aushärtung des Harzes erhaltenen Laminate.

Europäisches Patentamt

# EUROPÄISCHER RECHERCHENBERICHT

Nummer der Anmeldung
EP 94 81 0529

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X,Y | EP-A-0 477 724 (NIPPON KAYAKU KK)<br>* Seite 10, Zeile 26 - Zeile 28; Ansprüche; Beispiel 3 * | 1-7 | C08G59/32<br>C08G59/40<br>C08J5/24 |
| Y | DATABASE WPI<br>Derwent Publications Ltd., London, GB;<br>AN 89-029604<br>& JP-A-63 305 122 (MITSUBISHI RAYON KK)<br>13. Dezember 1988<br>* Zusammenfassung * | 1-7 | |
| A | EP-A-0 472 830 (IBM)<br>* Ansprüche; Beispiele * | 1 | |
| | | | RECHERCHIERTE SACHGEBIETE (Int.Cl.6) |
| | | | C08G<br>C08J |

Der vorliegende Recherchenbericht wurde für alle Patentansprüche erstellt

| Recherchenort | Abschlußdatum der Recherche | Prüfer |
|---|---|---|
| DEN HAAG | 23. Januar 1995 | Deraedt, G |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P04C03)